# EUROPEAN PATENT APPLICATION

(11) **EP 2 381 487 A1**
(43) Date of publication of application: **26.10.2011**
(21) Application number: 09838362.3
(22) Date of filing: 11.11.2009
(51) Int. Cl.: H01L 33/00, H01L 21/02, H01L 21/205, H01S 5/323

(54) **SUBSTRATE FOR LIGHT-EMITTING ELEMENT**

(30) Priority: 16.01.2009 JP 2009007854
(71) Applicant: Sumitomo Electric Industries, Ltd., Chuo-ku Osaka-shi Osaka 541-0041 (JP)
(72) Inventor: HACHIGO, Akihiro, Itami-shi Hyogo 664-0016 (JP); NAKAMURA, Takao, Itami-shi Hyogo 664-0016 (JP); YOSHIMURA, Masashi, Itami-shi Hyogo 664-0016 (JP)
(74) Representative: Grünecker, Kinkeldey, Stockmair & Schwanhäusser
(86) International application number: PCT/JP2009/069154
(87) International publication number: WO 2010/082396

(57) **Abstract**

The present invention is a minimal-defect light-emitting device substrate that enables emitted light to issue from a device's substrate side, and is a light-emitting device 100 substrate furnished with a transparent substrate 10 that is transparent to light of wavelengths between 400 nm and 600 nm, inclusive, and a nitride-based compound semiconductor thin film 1*c* formed onto one of the major surfaces of the transparent substrate 10 by a join. Letting the thermal expansion coefficient of the transparent substrate along a direction perpendicular to the major surface of the transparent substrate be α*₁*, and the thermal expansion coefficient of the nitride-based compound semiconductor thin film be α*₂*, then (α*₁ -* α*₂*) / α*₂* is between -0.5 and 1.0, inclusive, and at up to 1200°C the transparent substrate does not react with the nitride-based compound semiconductor thin film 1*c*. The absolute index of refraction of the transparent substrate 10 preferably is between 60% and 140%, inclusive, of the absolute index of refraction of the nitride-based compound semiconductor thin film.

## Description

### Technical Field

The present invention relates to substrates for light-emitting devices, and more specifically relates to a light-emitting device substrate that enables the degree of light-emitting-device design freedom to be raised.

### Background Art

Nitride semiconductor is often used to form light-emitting device substrates employed to create light-emitting devices such as LEDs. Compared with conventional semiconductors such as silicon, nitride semiconductor has a wide bandgap, and by varying the concentration of gallium, indium or aluminum used for the Group-III element, the breadth of the bandgap can be varied. Consequently, adjusting the breadth of the bandgap in the way just described makes it possible to design the wavelength of the light that light-emitting devices created utilizing such nitride semiconductor emit, in a broad range spanning almost the entire visible-light spectrum. For the forgoing reasons, nitride semiconductor is widely employed as a substrate for light-emitting devices.

In order to create light-emitting devices in instances in which gallium nitride, for example, is employed as a nitride semiconductor, preferably an epitaxial layer of gallium nitride is formed onto one of the major surfaces of a bulk substrate made of gallium nitride. (It should be noted that "major surfaces" herein refer to the principal sides having the greatest surface area among the surfaces.) Owing to their extraordinarily high cost, however, bulk substrates of gallium-nitride-based compound semiconductor are difficult to come by-meaning that the direct utilization of the material as a light-emitting device substrate is difficult.

On the other hand, attempting to form a multilayer structure of gallium nitride directly onto one of the major surfaces of a substrate-single-crystal silicon for example-that is lower-cost than bulk substrates of gallium-nitride-based compound semiconductor leads to the possibility that, due to causes including the difference in thermal expansion coefficient and the lattice mismatch between silicon and gallium nitride, thermal stress will arise in the single-crystal silicon substrate, giving rise to bowing in the silicon substrate, multilayer structure, etc. There is also a likelihood that troubles such as the gallium-nitride multilayer structure peeling off from the silicon substrate, the electrical characteristics of light-emitting devices formed on the gallium-nitride multilayer structure deteriorating, or the density of dislocations in the gallium-nitride multilayer structure increasing will arise.

Against this backdrop, below-cited Patent Reference 1, for example, discloses a substrate manufacturing method that will now be set forth. At first, a gallium nitride substrate is implanted with ions through one of its major surfaces to form, in the interior of the substrate relatively near the major surface, an ion-implantation layer oriented paralleling the major surface. The major surface through which ion implantation was carried out and a major surface of, e.g., a single-crystal silicon substrate, are then superimposed and subsequently heat treated. In this way the major surface, along the gallium nitride substrate, through which ion implantation was carried out and the major surface of the superimposed single-crystal substrate are joined, and at the same time a brittle region is formed in the ion-implantation layer. By the application of energy to the brittle region, the gallium nitride substrate can be separated away, forming onto the single-crystal silicon substrate a membrane of gallium nitride joined to the substrate. Because the membrane of gallium nitride peeled off at the brittle region is extremely thin, the gallium nitride substrate having separated from the single-crystal silicon substrate can used a number of times for carrying out the operations just described.

### Citation List

### Patent Literature

Patent Reference 1: Japanese Unexamined Pat. App. Pub. No. 2006-210660.

### Summary of Invention

### Technical Problems

Nevertheless, the method, disclosed in Patent Reference 1, of superimposing a gallium nitride substrate onto, and joining it together with, an undersubstrate of a qualitatively different substance does not mean that when the substrate is to be employed to manufacture light-emitting devices, an undersubstrate of a substance of choice may be utilized. That is, if a light-emitting device substrate of, for example, a gallium-nitride-based compound semiconductor as described above is to be produced, the substance of the undersubstrate that is superimposed and joined together with the gallium nitride substrate must be selected according to the goal for which the light-emitting device substrate is used.

For example, in the implementation, disclosed in Patent Reference 1, in which a gallium nitride substrate is superimposed onto and joined together with one of the major surfaces of a silicon substrate, on account of the silicon reacting with the gallium nitride due to the heat treatment and related processes when epitaxial layers are formed onto the gallium nitride membrane, pit-shaped defects (craters) can arise in the silicon substrate that is the substrate for the light-emitting devices, in part of the major surface that joins with the gallium nitride membrane. In the area where the defects have arisen, the silicon substrate and the gallium nitride membrane become unjoined. Consequently it can happen that owing to the defects developing, the surface area where the silicon substrate and the gallium nitride membrane are joined is lessened, therefore diminishing the strength with which the two are joined together.

Furthermore, in respect of light-emitting devices, demands are frequent that the preferred configuration be one that enables sending the emitted light along a direction that intersects the major surface of the multilayer structure and the undersubstrate, and passing it out to the exterior from the major-surface side of the undersubstrate. Yet in the implementation, disclosed in Patent Reference 1, with the light-emitting device substrate in which the undersubstrate is formed of silicon, the silicon single crystal does not for the most part transmit the visible light that the light-emitting devices emit. As a consequence, with the configuration of the light-emitting device substrate disclosed in Patent Reference 1, extracting light from a device's undersubstrate side is problematic, making it necessary to add separate operations that include lifting off the undersubstrate.

The present invention was brought about taking each problem discussed above into consideration, and an object thereof is to make available minimal-defect light-emitting device substrates that enable emitted light to issue from a device's substrate side.

### Solution to Problems

A substrate, involving the present invention, for light-emitting devices is a light-emitting device substrate furnished with a transparent substrate that is transparent to light of wavelengths between 400 nm and 600 nm, inclusive, and a nitride-based compound semiconductor thin film formed onto one of the major surfaces of the transparent substrate by a join. Letting the thermal expansion coefficient of the transparent substrate along a direction perpendicular to the major surface of the transparent substrate be α*₁*, and the thermal expansion coefficient of the nitride-based compound semiconductor thin film be α*₂,* then (α*₁ -* α*₂) l* α*₂* is between -0.5 and 1.0, inclusive, and at up to 1200°C the transparent substrate does not react with the nitride-based compound semiconductor thin film.

Light-emitting devices formed on the light-emitting device substrate furnished with the nitride-based compound semiconductor thin film are capable of emitting light within the wavelength range described above. Utilizing as an undersubstrate a transparent substrate that is transparent with respect to the light emitted-that is, that transmits the light at a high rate-makes it possible for the light that light-emitting devices formed on the light-emitting device substrate emit to pass through the undersubstrate and exit from the light-emitting surface on the back side of the undersubstrate (the major surface on the side of the undersubstrate reverse from the major surface along which it is joined with the nitride-based compound semiconductor).

And with the thermal expansion coefficient of the transparent substrate in the direction perpendicular to the major surface being in the above-noted range, the difference in thermal expansion coefficient with, for example, α*ₐ* = 5.59 × 10⁻⁶ (1/K), which is the thermal expansion coefficient along the α-axis of wurtzite-structure gallium nitride, is lessened. Therefore, the possibility that, when the transparent substrate is superimposed together with the nitride-based compound semiconductor substrate, troubles such as bowing of the substrate due to thermal stress originating in difference in thermal expansion coefficient will arise can be reduced.

Inasmuch as the above-described transparent substrate is superimposed together with the nitride-based compound semiconductor substrate by a join, the likelihood that difficulties due to lattice mismatch between the transparent substrate and the nitride-based compound semiconductor will arise can be reduced compared with, for example, instances in which nitride-based compound semiconductor is formed onto a transparent substrate by epitaxial growth. What is more, the transparent substrate has the property that it will not react with the nitride-based compound semiconductor thin film at the temperatures (up to 1200°C) at which a heating process is carried out when substrate is superimposed by the join described above. Consequently, the possibility is minimal that the nitride-based compound semiconductor substrate (or the nitride-based compound semiconductor thin film) and a portion of the major surface of the transparent substrate will react and form pits on the transparent substrate, in instances such as when it is being joined with the nitride-based compound semiconductor substrate and when epitaxial films are being formed onto the nitride-based compound semiconductor thin film having been created on the transparent substrate. Accordingly, the cohesion with which the transparent substrate and the nitride-based compound semiconductor thin film are joined can be advantageously maintained to make high-quality substrates available.

In a light-emitting device substrate involving the present invention, the absolute index of refraction of the transparent substrate preferably is between 60% and 140%, inclusive, of the absolute index of refraction of the nitride-based compound semiconductor.
Thus making the difference of the transparent substrate absolute index of refraction from the nitride-based compound semiconductor absolute index of refraction smaller enables reducing the possibility that the light that light-emitting devices formed on the major surface of the nitride-based compound semiconductor thin film emit will be lost due to reflecting in the join interface between the transparent substrate and the nitride-based compound semiconductor thin film.
Consequently, the light that the light-emitting devices emit can at a high rate be sent toward the transparent substrate and passed out through the major surface on the back side of the transparent substrate.

In order that it demonstrate the performance described above, the transparent substrate preferably is of at least one material selected from the group consisting of spinel, magnesium oxide, titanium oxide, alumina, sapphire, and aluminum nitride. While the transparent substrate may be a single crystal or a polycrystal, polycrystal, being lower cost, is the more preferable.

In a light-emitting device substrate involving the present invention, the surface roughness *Rₘₐₓ* of the major surface of the transparent substrate preferably is not greater than 2 nm. In particular, with the surface roughness *Rₘₐₓ* of the major surface of the transparent substrate where it joins with the nitride-based compound semiconductor thin film being within the range just given, the strength of the join between the transparent substrate and the nitride-based compound semiconductor thin film can be improved. In addition, the light that the light-emitting devices emit can be kept from scatteredly reflecting in the interface between the nitride-based compound semiconductor thin film and the transparent substrate, making it possible to transmit the light at a higher rate toward the transparent-substrate side. Likewise, when the transparent substrate and the nitride-based compound semiconductor thin film are joined, lower surface roughness *Rₘₐₓ* levels of both the major surfaces that are joined yields higher join strength.

With a light-emitting device substrate involving the present invention, a transparent thin film having an absolute index of refraction of between 60% and 140%, inclusive, of the absolute index of refraction of the nitride-based compound semiconductor, and being transparent to light of wavelengths between 400 nm and 600 nm, inclusive, preferably is furnished in between the transparent substrate and the nitride-based compound semiconductor thin film. Interposing the transparent thin film just described enables improving the strength of the join between the transparent substrate and the nitride-based compound semiconductor, and enables further reducing the surface roughness (improving the planarity) of the surfaces at the interface between the transparent substrate and the transparent thin film, and at the interface between the transparent thin film and the nitride-based compound semiconductor thin film.

The transparent thin film described above preferably is of at least one material selected from the group consisting of spinel, magnesium oxide, titanium oxide, alumina, and aluminum nitride. In particular, utilizing for the transparent thin film a material that is the same as that of the transparent substrate enables further improving the quality as a light-emitting device substrate.

### Advantageous Effects of Invention

The present invention makes possible the provision of high-quality light-emitting device substrates, in which the occurrence of defects is minimized, that enable emitted light to issue from a device's substrate side.

### Brief Description of Drawings

Fig. 1 is a simplified sectional view representing the disposition of a light-emitting device substrate in Embodying Mode 1 of the present invention.
Fig. 2 is a simplified sectional view of a nitride-based compound semiconductor bulk substrate.
Fig. 3 is a simplified sectional view representing a disposition in which ion implantation is carried out on the interior of a nitride-based compound semiconductor bulk substrate.
Fig. 4 is a simplified sectional view representing a disposition in which a major surface of a nitride-based compound semiconductor bulk substrate has been superimposed with one of the major surfaces of a transparent substrate.
Fig. 5 is a simplified sectional view representing a disposition in which a nitride-based compound semiconductor bulk substrate has given rise to fracturing.
Fig. 6 is a simplified sectional view representing the disposition of a light-emitting device substrate in Embodying Mode 2 of the present invention.
Fig. 7 is a simplified sectional view representing the disposition of a multilayer structure in an embodiment example of the present invention.
Fig. 8 is a simplified sectional view representing the disposition of a light-emitting device in an embodiment example of the present invention.

### Description of Embodiments

Below, while referring to the drawings a description of different modes of embodying the present invention will be made. It should be understood that with regard to the different embodying modes, elements that accomplish functions that are the same are labeled with reference marks that are the same, and explanation thereof, unless particularly necessary, will not be repeated.

### Embodying Mode 1

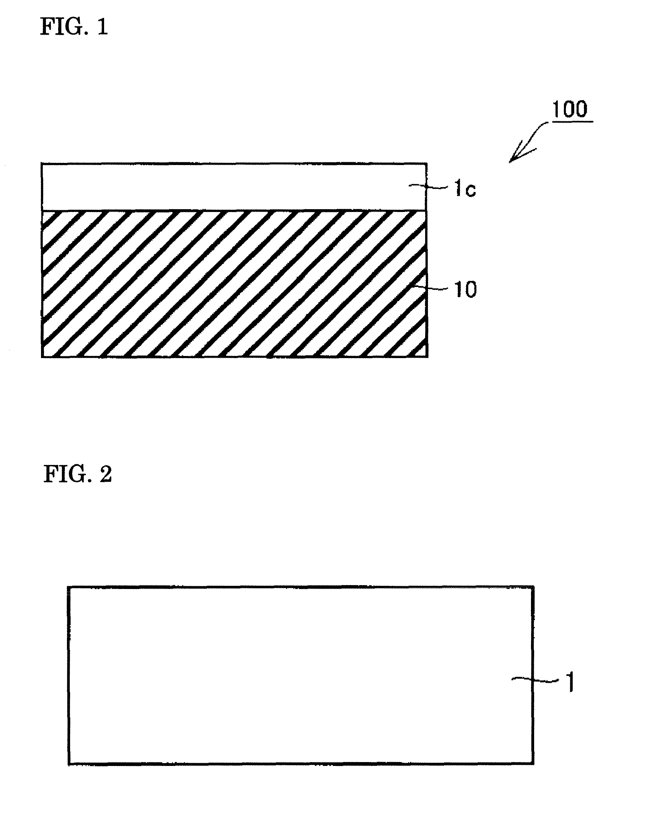

A light-emitting device substrate 100, represented in Fig. 1, is furnished with a transparent substrate 10 as an undersubstrate transparent to light of wavelengths between 400 nm and 600 nm, inclusive, and a nitride-based compound semiconductor thin film 1*c* formed on one of the major surfaces of the transparent substrate 10.

On the major surface of the nitride-based compound semiconductor thin film 1*c* that does not oppose the transparent substrate 10 (in Fig. 1, the major surface on the upper side), a multilayer structure of epitaxial laminae of gallium nitride (GaN), aluminum gallium nitride (AIGaN), and the like is formed, in order to create light-emitting devices. An epitaxial-laminar multilayer structure composed of these substances, in terms of accommodating differences in thermal expansion coefficient and lattice constant, can be readily formed on the major surface of the nitride-based compound semiconductor thin film 1*c*. Accordingly, on the light-emitting device substrate 100, a nitride-based compound semiconductor thin film 1*c* composed of, e.g., gallium nitride (GaN) is preferably furnished.

Gallium nitride is a semiconductor material employed as the constituent substance of blue light-emitting diodes (blue LEDs). Light-emitting devices employing nitride semiconductor are capable of issuing beams of almost the entire wavelength range of visible light generally; above all gallium nitride is chiefly capable of issuing visible light from blue to green, in a range of wavelengths from 400 nm to 600 nm, inclusive. Therefore, to have the light-emitting devices that have been formed onto the major surface of the nitride-based compound semiconductor thin film 1*c* in the light-emitting device substrate 100 emit light of wavelengths between 400 nm and 600 nm, inclusive, for example, a material that is transparent to light of this wavelength range is preferably utilized as the transparent substrate 10. It should be understood that "transparent" herein means that the extinction coefficient of the substrate with respect to a wavelength spectrum of between 400 nm and 600 nm, inclusive, wavelength is 0.01 or less.

Thus rendering the device substrate makes it possible, when light that a light-emitting device has emitted has advanced to the device substrate's transparent substrate 10 side, for the light to proceed through the interior of the transparent substrate 10, and to send the light out from the major surface on the back side of the transparent substrate 10 (the major surface on the underside in Fig. 1). Conventional light-emitting device substrates are often substrates of a specification according to which the optical emission is from the side on which the devices are formed. These days, however, demands for light-emitting device substrates that enable the light to issue not from the side where the devices are formed, but from the back side of the supporting substrate are on the rise. For such reasons, a light-emitting device substrate 100 of the present embodying mode, by utilizing the transparent substrate 10 as a supporting substrate, enables visible light from blue to green that a light-emitting device has emitted to issue at a high rate from the major surface on the back side of the transparent substrate 10. The degree of freedom for designing the light-emitting device substrate 100 and the light-emitting devices formed onto the substrate can therefore be improved.

The transparent substrate 10 in the light-emitting device substrate 100 is, as stated earlier, a material transparent to visible light from blue to green, in a range of wavelengths from 400 nm to 600 nm, inclusive, and at the same time it is preferable that, letting the thermal expansion coefficient of the transparent substrate 10 along a direction perpendicular to a major surface of the transparent substrate 10 (the up/down orientation in Fig. 1) be α*₁,* and the thermal expansion coefficient of the nitride-based compound semiconductor thin film 1*c* be α*₂,* (α*ᵣ* - α*₂*) / α*₂* be between -0.5 and 1.0, inclusive. A "direction perpendicular to a major surface of the transparent substrate 10" is a direction along which the nitride-based compound semiconductor thin film 1*c* and the transparent substrate 10 are joined (laminated). Accordingly, in the direction perpendicular to the major surface of the transparent substrate 10, by making the thermal expansion coefficient of the transparent substrate 10 approximate the thermal expansion coefficient of the nitride-based compound semiconductor thin film 1*c*, which is formed onto the major surface of the transparent substrate 10, when one of the major surfaces of the transparent substrate 10 and one of the major surfaces of the nitride-based compound semiconductor thin film 1*c* are joined by a heating process as will be described later, bowing, stresses, fracturing and like troubles in the light-emitting device substrate 100, owing to large thermal stress and lattice mismatch originating in difference in thermal expansion coefficient, can be kept from occurring.

During the just-mentioned joining of one of the major surfaces of the transparent substrate 10 and one of the major surfaces of the nitride-based compound semiconductor thin film 1*c* by a heating process, or when epitaxial layers are formed onto the nitride-based compound semiconductor thin film 1*c*, at the interface where the major surface of the nitride-based compound semiconductor thin film 1*c* and the major surface of the transparent substrate 10 contact it is preferable to minimize the occurrence of phenomena whereby physical defects form on account of a portion of the major surface of the transparent substrate 10 giving rise to chemical reaction with, and thermal stresses in, the opposing major surface of the nitride-based compound semiconductor thin film 1*c*. For that purpose, the transparent substrate 10 preferably consists of a substance that does not react with the nitride-based compound semiconductor thin film 1*c* at the temperatures at which the heating process is carried out when epitaxial layers are formed onto the nitride-based compound semiconductor thin film 1*c* (temperatures of up to 1200°C). The here-stated "does not react with the nitride-based compound semiconductor thin film 1*c*" means that when the major surface of the transparent substrate 10 and the major surface of the nitride-based compound semiconductor thin film 1*c* are superimposed and heated, neither a denatured layer nor chemical compounds form in between the two, or even if they should form, their thickness is not greater than 1 µm or the region where a denatured layer or chemical compounds have formed is a region that is not greater than 10% of the surface area of the superimposed major surfaces.

Discussed in the foregoing, the absolute index of refraction of the transparent substrate 10 preferably is between 60% and 140%, inclusive, of the absolute index of refraction of the nitride-based compound semiconductor thin film 1*c*. A considerable difference between the absolute index of refraction of the transparent substrate 10 and the absolute index of refraction of the nitride-based compound semiconductor thin film 1*c* gives rise to a situation in which from a light-emitting device, emitted light that is about to proceed, for example, from the nitride-based compound semiconductor thin film 1*c* toward the transparent substrate 10 becomes, depending on the incident angle of the light, readily reflected along the interface between the two, where the nitride-based compound semiconductor thin film 1*c* and the transparent substrate 10 are made to join. On account of this reflecting, from the light-emitting device emitted light that is about to proceed from the nitride-based compound semiconductor thin film 1*c* toward the transparent substrate 10 is obstructed from advancing toward the transparent substrate 10, such that the intensity of the emitted light diminishes. As a consequence, there is a possibility that the intensity of the light that passes out to the exterior of the light-emitting device substrate 100 from the major surface on the back side of the transparent substrate 10 will attenuate. In order to curb the foregoing sort of phenomena, the difference in absolute index of refraction between the nitride-based compound semiconductor thin film 1*c* and the transparent substrate 10 is preferably made small. Doing so makes it possible to minimize loss due to reflection of light along the interface where the two substrates join, and enables the light that the light-emitting device has emitted to be output unhindered from the major surface on the back side of the transparent substrate 10.

As the material of a transparent substrate 10 having the operational effects described above, at least one substance selected from the group consisting of spinel, magnesium oxide, titanium oxide, alumina, sapphire, and aluminum nitride is preferably utilized. A transparent substrate 10 of these substances will be, as described above, transparent to light of from 400 nm to 600 nm wavelength, emitted from blue diodes; its thermal expansion coefficient will be a value near the thermal expansion coefficient of wurtzite gallium nitride; and the value of its absolute index of refraction will fall within the range of 60% to 140% of that of gallium nitride. Furthermore, with a transparent substrate 10 of the aforementioned substances, in a state in which it is superimposed with a major surface of gallium nitride, for example, where the nitride-based compound semiconductor thin film 1*c* is formed, despite the heating process at temperatures of up to 1200°C being carried out, the possibility of the substrate reacting with the gallium nitride and forming pit-shaped defects (craters) will be slight, thanks to which performance as a high-quality light-emitting device substrate 100 can be demonstrated.

Next a method of manufacturing the light-emitting device substrate 100 will be described. To begin with, as shown in Fig. 2, a nitride-based compound semiconductor bulk substrate l, for example, consisting of gallium nitride, both of the major surfaces on the one side and the other side of which have been polished is prepared. The nitride-based compound semiconductor bulk substrate 1 is constituted from, e.g., a single crystal of wurtzitic gallium nitride, and the major surfaces are, for example, a configuration in which a round wafer having a two-inch diameter is provided with an "ori-fla" (orientation flat). The bulk substrate preferably is disposed in such a way that the one of the major surfaces (the major surface on the upper side in Fig. 2) will be a (000 1 ) nitrogen face and the other of the major surfaces, opposite the one major surface, (the major surface on the lower side in Fig. 2) will be a (0001) gallium face. Alternatively, one of the major surfaces of the nitride-based compound semiconductor bulk substrate 1 on which later-described ion implantation is carried out may be in an orientation having a within 8° tilt with respect to the (0001) face. Here, the single crystal constituting the nitride-based compound semiconductor bulk substrate 1 preferably has an electrical resistivity of 1 Ω·cm or less and a carrier concentration of 1E17 cm⁻³ or greater, and has an interiorly included dislocation density of not greater than 10⁹ cm⁻², more preferably not greater than 10⁷ cm⁻².

Next, ion implantation is carried out on the prepared nitride-based compound semiconductor bulk substrate 1. Herein the process is an operation carried out for supplying energy in order to create a brittle region in the interior of the nitride-based compound semiconductor bulk substrate 1.

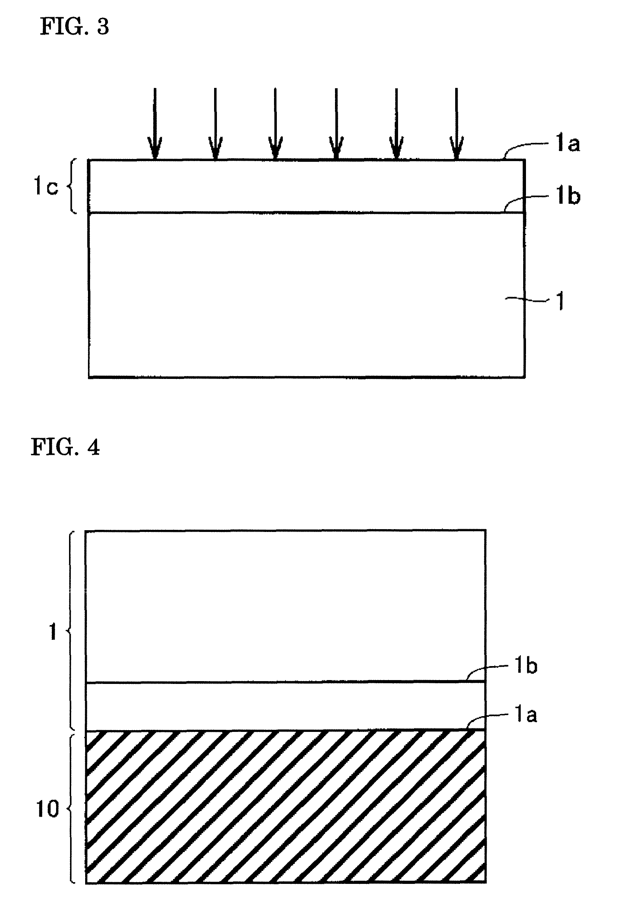

In Fig. 3, the downward pointing arrows are arrows indicating the disposition in which the ion implantation is carried out. Through the major surface 1*a* on one side of the nitride-based compound semiconductor bulk substrate 1 as indicated in Fig. 3, ion implantation with hydrogen ions, for example, is carried out. While the acceleration voltage at which the hydrogen ions accelerate is put at, e.g., 90 keV, and the dose at which the ion implantation is performed is put at, e.g., 7E17 cm⁻², it will be appreciated that a similar ion implanting process may be carried out under conditions in which the values are apart from those just stated. Herein it is preferable to have the major surface 1*a* where the ion implantation is carried out be the (0001) nitrogen face. Now in this ion implantation at least one substance selected from the group consisting of, for example, hydrogen, helium, nitrogen, oxygen, neon and argon is implanted into the interior of the nitride-based compound semiconductor bulk substrate 1 through one of its major surfaces. The substance utilized in the ion implantation is not limited to the substances just described, however; any given atoms that enable ionization to be carried out can be implanted. Nonetheless, utilizing a lighter atomic element-such as hydrogen, for example-having a low atomic number is more desirable because it enables the implantation depth to be deepened. And while a single atomic element (substance) may be implanted, a plurality of two or more atomic elements (substances) may be implanted. Carrying out the given ion implantation deploys the implanted ions in a region at a uniform depth from the major surface 1*a* of the nitride-based compound semiconductor bulk substrate 1, in a direction that intersects the major surface 1*a*, with the region forming an ion implantation region 1*b*.

Next, the major surface 1*a* of the nitride-based compound semiconductor bulk substrate 1 is superimposed with one of the major surfaces of the transparent substrate 10. In Fig. 4, a transparent substrate 10 having a uniform thickness and satisfying the conditions described above is readied, and the nitride-based compound semiconductor bulk substrate 1 is superimposed onto the one of the major surfaces (the major surface on the upper side in Fig. 4) of the transparent substrate 10, situating the two so as to be in tight contact. That is, in Fig. 4, the nitride-based compound semiconductor bulk substrate 1 is up/down reversed from the state shown in Fig. 3, with the major surface 1*a* where ion implantation was carried out situated so as to be superimposed with the major surface of the transparent substrate 10.

While the state indicated in Fig. 4 is maintained, heating is carried out inside a heat-processing furnace, for example, to perform a heating process whereby the major surface 1*a* of the nitride-based compound semiconductor bulk substrate 1 is joined with the major surface of the transparent substrate 10. As to the heating conditions during this operation, carrying it out for 2 hours at 300°C, for example, makes it possible to further heighten the strength of the join between the nitride-based compound semiconductor bulk substrate 1 and the transparent substrate 10. These conditions also make it possible to lift off the nitride-based compound semiconductor bulk substrate 1 along the ion implantation region 1*b* that is the brittle region formed by ion implantation. Here, in order to keep the nitride-based compound semiconductor bulk substrate 1 and transparent substrate 10 from causing bowing and like deformations due to the heating, it is preferable to have the heating temperature in the present process be not greater than 1200°C. It should be noted that other methods of choice may be utilized as ways to join the major surface 1*a* and the transparent substrate 10.

Herein, with regard to the joined-together major surface 1*a* and transparent-substrate 10 major surface, in order to heighten the joining strength of the two, a surface treatment that lessens the surface roughness *Rₘₐₓ* of the major surfaces is preferably implemented in advance. Specifically, it is preferable to implement a surface treatment on the major surface 1*a* and the transparent-substrate 10 major surface so as to bring the roughness level (the maximum height *Rₘₐₓ*) to 2 nm or less. For the surface treatment herein, it is preferable to employ, for example, a method such as wet-etching, mechanical surface polishing, chemical mechanical planarization (CMP) or other chemical-mechanical polishing technique. In this way getting the surface roughness of the major surfaces where the nitride-based compound semiconductor bulk substrate 1 and the transparent substrate 10 join down to a minimum heightens the join strength of the two, and at the same time minimizes phenomena such as, for example, scattered reflecting along the interface between the nitride-based compound semiconductor bulk substrate 1 and the transparent substrate of the light emitted from the gallium nitride side 10. The light therefore can be transmitted and passed smoothly toward the transparent-substrate 10 side.

As a way of joining the nitride-based compound semiconductor bulk substrate 1 and the transparent substrate 10 as indicated in Fig. 4, a technique of bringing the surface roughness *Rₘₐₓ* of the joining faces down to a minimum, as described above, and in a state in which the surfaces have been made specular, carrying out a heating process while a load is applied between the two substrates may be utilized. Instead of that, a technique of exposing the above-described nitride-based compound semiconductor bulk substrate 1 and transparent substrate 10 within a plasma atmosphere, for example, and joining them in the manner just noted may be utilized. Alternatively, a technique of joining them by using plasma particles, ion particles and neutral particles within a vacuum atmosphere to bombard the joining surfaces, or a technique of joining them by interposing a glass or like substance between them and applying an electric field to the join interface may also be utilized.

As described earlier, during ion implantation performed prior to joining being carried out, a brittle region that will serve as a base that brings about a rupture is formed in the interior of the ion implantation region 1*b* by the ion implantation. Therein, when a heating process is utilized along the join between the nitride-based compound semiconductor bulk substrate 1 and the transparent substrate 10, numerous dangling bonds, originating in the brittle region in the interior of the ion implantation region 1*b*, form. Therefore, implementing the heating process on the gallium nitride bulk region containing the ion implantation region 1*b* and transparent substrate 10 brings about a rupture in the ion implantation region 1*b* due to the heat energy, turning the ion implantation region 1*b* into a fracture layer. Accordingly, performing heating in a situation in which superimposing in the dispositional state represented in Fig. 4 has been carried out causes the implantation region 1*b* to fracture. As a result, the nitride-based compound semiconductor bulk substrate 1 is split into two regions along the ion implantation region 1*b*, leaving a state in which only the region that had been sandwiched between the major surface 1*a* and the ion implantation region 1*b* is joined with the transparent substrate 10. This is a lifting-off of the nitride-based compound semiconductor bulk substrate 1 along its brittle region.

It will be appreciated that in carrying out the process of separating the ion implantation region 1*b* from the nitride-based compound semiconductor bulk substrate 1, the imparting of heat energy to the ion implantation region 1*b* in the manner just noted is preferable. Nevertheless, the separation process may be carried out by imparting, instead of heat energy, mechanical energy or other external force, or optical energy, or else by the jetting of high-pressure gas or liquid.

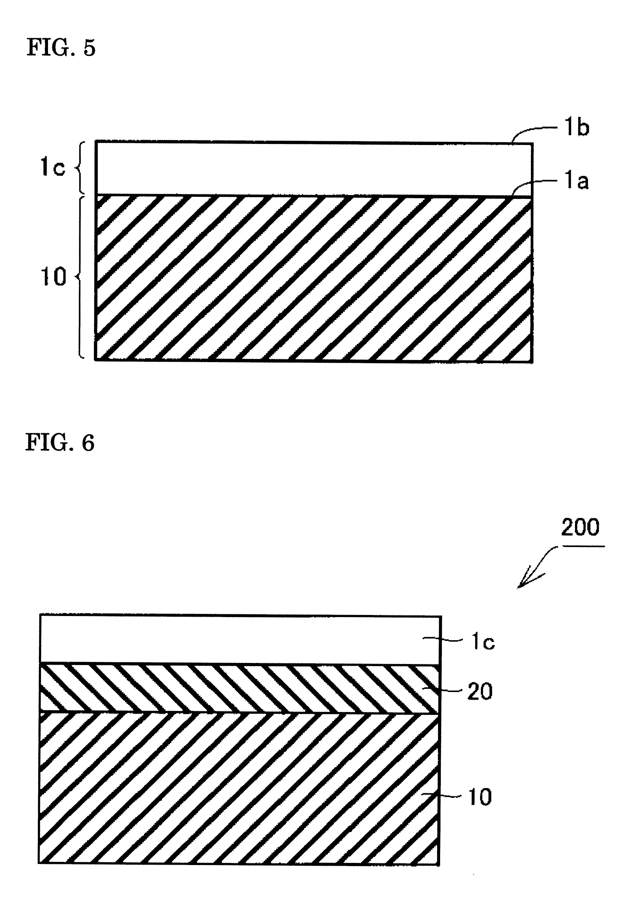

As described above, with the nitride-based compound semiconductor bulk substrate 1, the fact that during the heating process fracturing occurs along the ion implantation region 1*b* leads to a state in which only the nitride-based compound semiconductor thin film 1*c* sandwiched between the major surface 1*a* and the ion implantation region 1*b* is joined to the major surface of the transparent substrate 10. Herein, the thickness of the nitride-based compound semiconductor thin film 1*c* (the thickness along a vertical axis in Fig. 5, intersecting the major surface) is substantially equal to the depth to which the ion implantation region 1*b*, ion-implanted into the nitride-based compound semiconductor bulk substrate 1, forms. While the depth to which the ion implantation region 1*b* forms depends on the type of ions implanted and on the acceleration energy of the ions in the ion implantation, because it will be a depth of 30 µm or less from the major surface 1*a* of the nitride-based compound semiconductor bulk substrate 1, the thickness of the nitride-based compound semiconductor thin film 1*c* formed on the major surface of the transparent substrate 10 will also be in a unit of 30 µm or less. In this way, the light-emitting device substrate 100 represented in Fig. 1 is created.

Instead of the transparent substrate 10, if for example a silicon substrate is employed, the likelihood of defects in the form of pits (craters) developing on the major surface of the silicon substrate where it would be joined with a gallium nitride thin film would be high. In contrast, in the light-emitting device substrate 100, the likelihood of such defects in the form of pits (craters) developing is low. In the light-emitting device substrate 100, therefore, sufficient joining surface area and joining strength between the nitride-based compound semiconductor thin film 1*c* and the transparent substrate 10 can be secured.

Accordingly, by the aforedescribed process being carried out a single time, the region that separates from the nitride-based compound semiconductor bulk substrate 1 to become the nitride-based compound semiconductor thin film 1*c* is a very thin region by comparison to the nitride-based compound semiconductor bulk substrate 1 in its entirety. If for example the thickness of the nitride-based compound semiconductor bulk substrate 1 is 1 mm, then from a single nitride-based compound semiconductor bulk substrate 1 plate, it would be possible to carry out the above-described process of forming a nitride-based compound semiconductor thin film 1*c* several dozen times to several hundred times. This fact means that it is possible to create light-emitting device substrates for which a method in the present embodying mode has been utilized at low cost compared with light-emitting device substrates in which an epitaxial layer of gallium nitride or the like is formed directly onto the major surface of a nitride-based compound semiconductor bulk substrate 1.

Furthermore, a nitride-based compound semiconductor thin film 1*c* formed as a membrane onto one of the major surfaces of the transparent substrate 10 by an aforedescribed method will, even should the lattice constant of the gallium nitride differ from the lattice constant of the material forming the transparent substrate 10, be disposed stably on the major surface of the transparent substrate 10, without giving rise to detrimental issues such as lattice mismatch between the transparent substrate 10 and the nitride-based compound semiconductor thin film 1*c*, increase in dislocation density within the nitride-based compound semiconductor thin film 1c, or peeling off of the nitride-based compound semiconductor thin film 1*c*. This is because it is not that the nitride-based compound semiconductor thin film 1*c* is formed by epitaxial growth onto the major surface of the transparent substrate 10, but rather is that it is a structure in which a nitride-based compound semiconductor thin film 1*c* having been created as a construct beforehand is joined to the major surface of the transparent substrate 10.

In implementations with the above-described light-emitting device substrate 100 in which a nitride-based compound semiconductor thin film 1*c* is joined onto the major surface of the transparent substrate 10, the ion implantation region 1*b* of the nitride-based compound semiconductor thin film 1*c* forms the surface of a multilayer structure on the light-emitting device substrate 100, and light that a light-emitting device formed on the surface of the ion implantation region 1*b* emits is from blue to green visible light, having a wavelength on the order of 400 nm to 600 nm, as described above. But by controlling the material properties of the Group III compound semiconductor that is joined to the major surface of the transparent substrate 10, and the atomic fraction of the Group III element(s) contained in the compound semiconductor, the wavelength of the light that the light-emitting device outputs can be designed to span a broad range of, for example, from red light to ultraviolet rays.

It should be understood that instead of the manufacturing method, described in the foregoing, in which the brittle region formed by ion implantation is utilized to lift off the nitride-based compound semiconductor bulk substrate 1 having been superimposed on the transparent substrate 10, the manufacturing method set forth below may be utilized. Namely, to begin with, as an operation whereby a substrate and nitride-based compound semiconductor bulk are joined, one of the major surfaces of a nitride-based compound semiconductor bulk substrate 1 on which ion implantation has not been performed is superimposed with one of the major surfaces of a transparent substrate 10 similar to the above-described, and a process of joining the two by, e.g., heating them is carried out. Here, another method of choice may be utilized as the joining method. Subsequently, as an operation whereby the nitride-based compound semiconductor bulk is made into a thin film, a process is carried out on the nitride-based compound semiconductor bulk substrate 1 joined to the transparent substrate 10 in order to render the bulk substrate a nitride-based compound semiconductor thin film 1*c* having a desired thickness. Specifically, for example a CMP apparatus is employed to polish the nitride-based compound semiconductor bulk substrate 1 through the major surface on the reverse side from the major surface where it is joined to the transparent substrate 10, or for example a process of employing a wire saw to slice (sever) the nitride-based compound semiconductor bulk substrate 1 so that the portion joined to the transparent substrate 10 will be a desired thickness is carried out.

This means that a nitride-based compound semiconductor thin film 1*c* formed by means of a join onto the major surface of a transparent substrate 10, as in the foregoing, on which ion implantation has not been carried out contains no damage due to ion implantation. A light-emitting device substrate 100 having a nitride-based compound semiconductor thin film 1*c* of quality that is higher still than that of a light-emitting device substrate 100 created exploiting the aforedescribed lift-off by means of ion implantation can therefore be made available.

### Embodying Mode 2

The light-emitting device substrate 200 represented in Fig. 6 is lent a disposition that is basically similar to that of the light-emitting device substrate 100 represented in Fig. 1. The light-emitting device substrate 200, however, is further furnished with a transparent thin film 20 in between the transparent substrate 10 and the nitride-based compound semiconductor thin film 1*c*. In the just-stated respect alone, the light-emitting device substrate 200 differs from the light-emitting device substrate 100.

The transparency of the transparent thin film 20, like the transparency of the transparent substrate 10, signifies being transparent to light of between 400 nm and 600 nm wavelength, inclusive. Likewise, the transparent thin film 20 preferably also is constituted from a substance having an absolute index of refraction that is between 60% and 140%, inclusive, of the absolute index of refraction of gallium nitride; specifically the substance preferably is at least one selected from the group consisting of spinel, magnesium oxide, titanium oxide, alumina, and aluminum nitride. Nevertheless, given that the transparent thin film 20 is formed onto one of the major surfaces of the transparent substrate 10, it is preferable to make the elemental constituent of the transparent thin film 20 be identical with the elemental constituent of the transparent substrate 10. Doing so allows the transparent thin film 20 to form extremely stably onto the major surface of the transparent substrate 10.

The transparent thin film 20 is preferably formed onto the one of the major surfaces of the transparent substrate 10-that is, onto the major surface on the side where the nitride-based compound semiconductor thin film 1*c* is formed (the major surface on the upper side in Fig. 6)-utilizing, for example, a vacuum vapor deposition, sputtering, or MOCVD technique. However, because it is desirable to form a transparent thin film 20 of favorable film quality so as not to roughen the major surface of the transparent substrate 10, among the methods just listed, utilizing a sputtering technique or MOCVD technique is particularly preferable. It is also preferable to have the thickness of the transparent thin film 20 be between 0.05 µm and 10 µm, inclusive, and, especially, having it be between 0.1 µm and 2 µm, inclusive, is more preferable still.

By superimposing the major surface on one side of the transparent thin film 20 (the major surface on the upper side in Fig. 6) and the major surface 1*a* of a nitride-based compound semiconductor bulk substrate 1, and dividing the nitride-based compound semiconductor bulk substrate 1 along the ion implantation region 1*b*, the light-emitting device substrate 200 represented in Fig. 6 can be created. With the light-emitting device substrate 200, on account of the transparent thin film 20 being sandwiched in between the transparent substrate 10 and the nitride-based compound semiconductor thin film 1*c*, having the planarity of the front side of the transparent thin film 20 (the face in contact with the nitride-based compound semiconductor thin film 1*c*) be still better enables the strength of the join between the transparent thin film 20 and the transparent thin film 20 to be heightened further. And the rate at which light that the light-emitting devices emit is transmitted toward the transparent thin film 20 and the transparent substrate 10 can be heightened, while the output strength from the major surface on the back side of the transparent substrate 10 of light the light-emitting devices emit can be further heightened.

Embodying Mode 2 of the present invention differs from Embodying Mode 1 of the present invention only in the respects set forth above. That is, the constitutional makeup and conditions, the procedures and effects, etc. not described above in respect of Embodying Mode 2 of the present invention all correspond to those of Embodying Mode 1 of the present invention.

### Embodiment Example 1

Utilizing a method of manufacturing a light-emitting device substrate 100, disclosed in Embodying Mode 1 described above, a nitride-based compound semiconductor thin film was actually formed and a light-emitting device created. The procedure therefor is explained in the following.

At first, as the nitride-based compound semiconductor bulk substrate 1 represented in Fig. 2, a gallium nitride wafer of two inches diameter and 500 µm thickness that, upon being doped with oxygen, had been polished to a specular finish on the one side and the other side, on both the major surfaces, was readied. The gallium nitride wafer had a hexagonal crystallographic structure, and its major surfaces were (0001) planes. Also, its resistivity was not greater than 1 Ω·cm and its carrier concentration was not less than 1E17 cm⁻³.

On the nitrogen face, the major surface on one side of the gallium nitride wafer, hydrogen ions were implanted as indicated in Fig. 3. For this operation the voltage at which the hydrogen ions were accelerated was made 90 keV, and the dose was made 7E 17 cm⁻². After the ion implantation region 1*b* indicated in Fig. 3 was in this way formed in the interior of the gallium nitride wafer, the major surface 1*a* of the gallium nitride wafer where the ion implantation was carried out was washed. Further, the gallium nitride wafer was introduced into a dry etching apparatus, and by electrically discharging the major surface 1*a* within an argon gas atmosphere, the plasma was employed to carry out a process (plasma etching) to eliminate microparticles and debris clinging to the major surface 1*a*, and eliminate residual stress and crystal warpage in the vicinity of the major surface 1*a*. Herein, the argon gas conditions in the dry-etching apparatus interior were a radio-frequency power of 100 W, and an argon gas flow rate of 50 sccm, with the pressure of the atmosphere being made 6.7 Pa.

Meanwhile, as the transparent substrate 10 represented in Fig. 1 and Fig. 4, for example, a transparent substrate of polycrystalline spinel was utilized, and by discharging it within the argon gas atmosphere, plasma etching of the major surface was carried out under the same conditions as with the above-described gallium nitride wafer.

Then, within atmospheric air a process was carried out whereby the major surface 1*a* of the gallium nitride wafer as a nitride-based compound semiconductor bulk substrate 1, and the major surface, on which the plasma process had been carried out, of the polycrystalline spinel transparent substrate 10 were superimposed as indicated in Fig. 4. Here, after the two substrates were superimposed, in order to heighten the strength of the adhesion between the two, they were heated within a heating furnace at 300°C for two hours, within a nitrogen atmosphere. The heating caused lift-off of the gallium nitride wafer along the ion implantation region 1*b* indicated in Fig. 4, creating the light-emitting device substrate 100 represented in Fig. 5 (Fig. 1), furnished with a nitride-based compound semiconductor thin film 1*c*. It should be noted that inasmuch as the thermal expansion coefficient α*₁* of polycrystalline spinel is 7.4 × 10⁻⁶ (1 / K), and the (α-axis oriented) thermal expansion coefficient α₂ of gallium nitride is around 5.6 × 10⁻⁶ (1 /K), the value (α*₁ -* α*₂*)/α*₂* satisfies the condition of being between -0.5 and 1.0, inclusive.

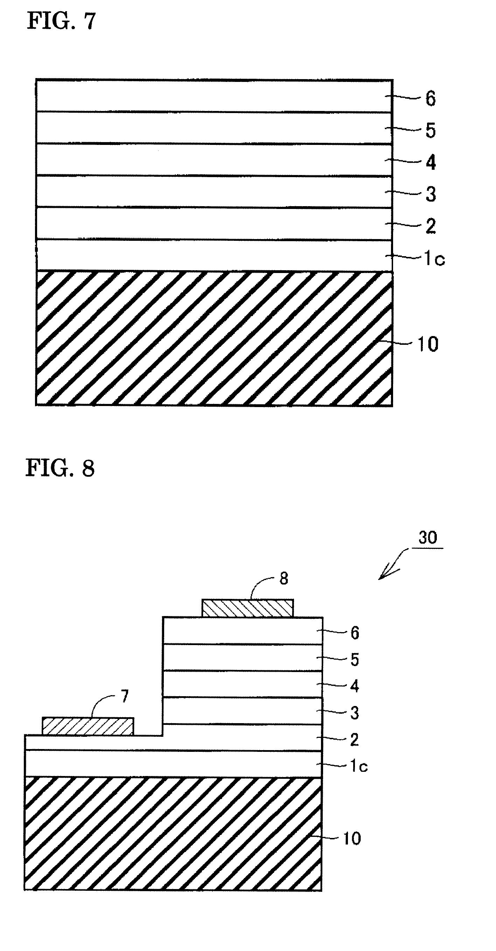

Onto the topmost face of the light-emitting device substrate 100-its major surface (in Fig. 5, the ion implantation region 1*b*)-a light-emitting device was formed by the use of an MOCVD technique. Specifically, as represented in Fig. 7, an *n*-type gallium nitride layer 2, an n-type aluminum gallium nitride layer 3, a multiquantum well layer 4, a *p*-type aluminum gallium nitride layer 5, and a *p*-type gallium nitride layer 6 were formed in that order in part. Also, the multiquantum well layer 4, which is the light-emitting layer, was rendered a configuration in which extremely thin membranes of In₀.₂Ga₀.₈N and extremely thin membranes of Al_{0.2}Ga_{0.8}N were laminated in alternation.

Part of the multilayer structure formed as described above-specifically, a portion of the n-type gallium nitride layer 2, as well as the *n*-type aluminum gallium nitride layer 3, the multiquantum well layer 4,n the *p*-type aluminum gallium nitride layer 5, and the *p*-type gallium nitride layer 6-was removed by etching. In this way the structure was put into a state in which a portion of the major surface of the n-type gallium nitride layer 2, and the major surface of the *p*-type gallium nitride layer 6 were exposed.

Then, as indicated in Fig. 8, atop the major surfaces of the partially exposed n-type gallium nitride layer 2 and *p*-type gallium nitride layer 6 just described, a metal material for making ohmic contacts was used to form, respectively, an n-type electrode 7 and a *p*-type electrode 8.

By the foregoing procedure, the light-emitting device 30 depicted in Fig. 8 was created. Passing a current between the *n*-type electrode 7 and *p*-type electrode 8 of the light-emitting device 30 gives rise to recombining of holes and electrons in the multiquantum well layer 4 that is the light-emitting layer, producing a light-emission phenomenon. It could be confirmed that the light issued (was transmitted) from the back side of the transparent substrate 10 (the major surface on the underside of the transparent substrate 10 in Fig. 8).

### Embodiment Example 2

The formation of a light-emitting device substrate 100 similar to that of Embodiment Example 1 was attempted utilizing as the elemental constituent of the transparent substrate 10, instead of polycrystalline spinel, quartz having an absolute index of refraction of 140% of the absolute index of refraction of the gallium nitride forming the nitride-based compound semiconductor thin film 1*c*. However, in the operation of superimposing the major surface of the transparent substrate 10 (the quartz substrate) and the gallium-nitride wafer major surface on which ion implantation had been conducted, and carrying out heating to give rise to lift-off along the ion implantation region, cracks developed in the gallium nitride wafer, such that forming the light-emitting device substrate 100 was not possible.

This originated in the fact that the difference in thermal expansion coefficient between quartz and gallium nitride is large. Specifically, the thermal expansion coefficient α*₁*, of quartz is 5.4 × 10⁻⁷ (1 /K) and the (*a*-axis oriented) thermal expansion coefficient α*₂* of gallium nitride is around 5.6 × 10⁻⁶ (1/K), meaning that the value (α*₁* - α*₂*) / α*₂* is less than -0.5. Therefore the cracking presumably originated in thermal stress owing to the difference in thermal expansion coefficient.

### Embodiment Example 3

A gallium nitride substrate of two inches diameter was utilized as the nitride-based compound semiconductor bulk substrate 1 represented in Fig. 2, and an MOCVD technique was employed to form on one of the major surfaces thereof an aluminum gallium nitride layer, similar to the n-type aluminum gallium nitride layer 3 indicated in Fig. 7, of 2 µm thickness. Hydrogen ion implantation through the topmost face, being the major surface, of the aluminum gallium nitride layer into the interior of the aluminum gallium nitride layer as in Fig. 3 was then carried out. The hydrogen-ion acceleration voltage for the process was made 100 keV, while the dose was made 6E17 cm⁻².

After the hydrogen ion implantation was carried out, in the same way as with Embodiment Example 1 the major surface where the ion implantation was carried out was washed. Further, the gallium nitride substrate was introduced into a dry etching apparatus, and by electrically discharging the major surface of the aluminum gallium nitride layer within an argon gas atmosphere, the plasma was employed to carry out a process (plasma etching) to eliminate microparticles and debris clinging to the major surface, and eliminate residual stress and crystal warpage in the vicinity of the major surface. Then, in the same way as with Embodiment Example 1, the major surface of the aforedescribed aluminum gallium nitride layer, and along a sapphire substrate utilized as the transparent substrate 10, the major surface on which the plasma etching had been carried out were superimposed within atmospheric air.

Then, in order to heighten the strength of the adhesion between the two, they were heated within a heating furnace at 400°C for two hours, within a nitrogen atmosphere. The heating caused lift-off of the aluminum gallium nitride layer on the gallium nitride substrate, along the ion implantation region 1*b* (cf. Fig. 4), creating the light-emitting device substrate 100 represented in Fig. 5 (Fig. 1), with the aluminum gallium nitride layer being the nitride-based compound semiconductor thin film 1*c*, and the sapphire substrate being the transparent substrate 10. It should be noted that inasmuch as the thermal expansion coefficient α*₁* of the sapphire substrate is 7.1 × 10⁻⁶ (1/K), and the (α-axis oriented) thermal expansion coefficient α*₂* of aluminum gallium nitride is around 5.6 × 10⁻⁶ (1/K), the value (α*₁* - α*₂)*/α*₂* satisfies the condition of being between-0.5 and 1.0, inclusive.

Lamination similar to that of Fig. 8 was carried out employing MOCVD on the light-emitting device substrate 100 that had been created, whereby a light-emitting device 30 like that of Fig. 8 was built. The light-emitting device 30 was then operated by passing a current through it, confirming that the emitted light issued (was transmitted) from the back side of the transparent substrate 10 (the major surface on the underside of the transparent substrate 10 in Fig. 8).

### Embodiment Example 4

The relationship between the surface roughness *Rₐ* of the major surface 1*a* of the light-emitting device substrate 100 (cf. Fig. 5) created in Embodiment Example 1, where the surface is joined with the transparent substrate 10, and the rate (optical transmission rate) at which the light that the light-emitting device 30 (cf. Fig. 8) built on the light-emitting device substrate 100 emits passes (is transmitted) through the back side of the transparent substrate 10 was examined.

According to the conditions under which the major surface 1*a* was plasma-etched in Embodiment Example 1, a total of four types of gallium nitride wafers, ones where the roughness *Rₐ* of the major surface 1*a* was made 2.4 nm, 2.1 nm and 1.9 nm, and one where it was made 1 nm were prepared. These were superimposed on the major surface of transparent substrates 10 (polycrystalline spinel) as described in Embodiment Example 1 to create light-emitting device substrates 100.

Therein, the surface area of the region where the major surface 1*a* of the gallium nitride wafer and the major surface of the transparent substrate 10 cohere (the surface area of the join) was investigated for each surface roughness *Rₐ* of the major surfaces l*a*. In addition, for the respective light-emitting device substrates 100, the amount of the light incident through the nitride-based compound semiconductor thin film 1*c* side of the transparent substrate 10 that issued from the major surface on the side reverse from the major surface opposing the nitride-based compound semiconductor thin film 1*c* was investigated. The results, expressed as "Join surface area (%)" and "Optical transmission rate" with, as a referent, the sample in which the roughness *Rₐ* of the major surface 1*a* was 1 nm are Table I below.

**Table I**

| Roughness *Ra* [nm] of GaN major surface 1*a* | Join surface area [%] | Optical transmission rate |
|---|---|---|
| 2.4 | 35 | 0.77 |
| 2.1 | 67 | 0.83 |
| 1.9 | 84 | 0.92 |
| 1 | 100 | 1 |

From Table I: With larger roughness *Rₐ* of the major surface of the superimposed gallium nitride, the surface area of the join with the transparent substrate 10 grows smaller. The consequence is that the rate of light, incident through the devices' gallium nitride wafer side, that is transmitted through the aforementioned region where it is superimposed and issues from the back side of the transparent substrate 10 is reduced. The foregoing facts were confirmed by way of Embodiment Example 4.

The presently disclosed embodying modes and embodiment examples should in all aspects be considered to be illustrative and not limiting. The scope of the present invention is set forth not by the foregoing embodying modes and embodiment examples, but by the scope of the patent claims, and is intended to include meanings equivalent to the scope of the patent claims and all modifications within the scope.

### Industrial Applicability

The present invention is particularly distinguished as technology that makes available high-quality light-emitting device substrates that enable emitted light to be passed through a device's substrate side.

### Reference Signs List

**1:** nitride-based compound semiconductor bulk substrate; **1*a*:** major surface; **1*b:*** ion implantation region; **1*c*:** nitride-based compound semiconductor thin film; **2:** *n*-type gallium nitride layer; **3:** *n*-type aluminum gallium nitride layer; **4:** multiquantum well layer; **5:** *p*-type aluminum gallium nitride layer; **6:** *p*-type gallium nitride layer; **7:** *n*-type electrode; **8:** *p*-type electrode; **10:** transparent substrate; **20:** transparent thin film; **30:** light-emitting device; **100, 200:** light-emitting device substrates

## Claims

1. A light-emitting device substrate comprising:
a transparent substrate that is transparent to light of wavelengths between 400 nm and 600 nm, inclusive; and
a nitride-based compound semiconductor thin film formed onto one of the major surfaces of the transparent substrate by a join;
being a light-emitting device substrate wherein
letting the thermal expansion coefficient of said transparent substrate along a direction perpendicular to the major surface of said transparent substrate be α*₁*, and the thermal expansion coefficient of said nitride-based compound semiconductor thin film be α*₂*, then (α*₁, -* α*₂) l* α*₂* is between -0.5 and 1.0, inclusive, and
said transparent substrate is not reactive with said nitride-based compound semiconductor thin film at temperatures of up to 1200°C.

2. The light-emitting device substrate set forth in claim 1, wherein the absolute index of refraction of said transparent substrate is between 60% and 140%, inclusive, of the absolute index of refraction of said nitride-based compound semiconductor thin film.

3. The light-emitting device substrate set forth in claim 1 or 2, wherein said transparent substrate is of at least one material selected from the group consisting of spinel, magnesium oxide, titanium oxide, alumina, sapphire, and aluminum nitride.

4. The light-emitting device substrate set forth in any one of claims 1 through 3, wherein the surface roughness *Rₘₐₓ* of the major surface of said transparent substrate is not greater than 2 nm.

5. The light-emitting device substrate set forth in any one of claims 1 through 4, further comprising, in between said transparent substrate and said nitride-based compound semiconductor thin film, a transparent thin film having an absolute index of refraction of between 60% and 140%, inclusive, of the absolute index of refraction of said nitride-based compound semiconductor thin film, and being transparent to light of wavelengths between 400 nm and 600 nm, inclusive,

6. The light-emitting device substrate set forth in claim 5, wherein said transparent thin film is of at least one material selected from the group consisting of spinel, magnesium oxide, titanium oxide, alumina, and aluminum nitride.
